# EUROPEAN PATENT SPECIFICATION

(11) **EP 2 797 272 B1**
(45) Date of publication and mention of the grant of the patent: **31.01.2018**
(21) Application number: 14165517.5
(22) Date of filing: 22.04.2014
(51) Int. Cl.: H03M 1/00, H03M 1/36, H04L 25/49, H04L 25/05, H03M 5/20, H04L 25/03, H04L 27/06, H04L 25/06

(54) **Stacked comparator topology for multi-level signaling**
Gestapelte Vergleichertopologie zur mehrstufigen Signalisierung
Topologie de comparateur empilée pour une signalisation multiniveau

(30) Priority: 22.04.2013 US 201361814759 P; 23.01.2014 US 201414162648
(43) Date of publication of application: 29.10.2014
(73) Proprietor: Samsung Display Co., Ltd., Gyeonggi-do (KR)
(72) Inventor: Hekmat, Mohammad, San Jose, CA California 95112 (US)
(74) Representative: Mounteney, Simon James

(56) References cited:
- US-A- 5 793 816
- US-A1- 2008 174 343
- US-B1- 6 377 073
- SHRUTI K OZA ET AL: "Low Power Folding and Interpolating ADC Using 0.18 mu-m Technology", ADVANCES IN COMPUTER ENGINEERING (ACE), 2010 INTERNATIONAL CONFERENCE ON, IEEE, PISCATAWAY, NJ, USA, 20 June 2010 (2010-06-20), pages 54-58, XP031720819, ISBN: 978-1-4244-7154-6

## Description

### FIELD

The present invention relates to multi-level signaling and more particularly to a low-power, high-speed system and method for receiving a signal employing multi-level signaling.

### BACKGROUND

When a digital signal is transmitted across a data bus using two levels, i.e., binary signaling, the signal switches between two values, representing a binary 0 or 1, respectively. For example, the voltage on a conductor, such as a wire or a printed wiring board trace, may be driven to a first value to signify a binary 0 and to a second value to signify a binary 1.

Data may be sent across a bus at a higher data throughput, for a given clock rate, using multi-level signaling. For example, in four-level signaling, which may be referred to as four-level pulse amplitude modulation (PAM-4), the voltage on conductor may take one of four values. In a PAM-4 receiver the received signal may then be converted, for each of the four voltage values, to a pair of bits, with a first value corresponding to binary 00, a second value corresponding to binary 01, a third value corresponding to binary 10, and a fourth value corresponding to binary 11, respectively. In other embodiments the correspondence between the voltage levels and pairs of bits may be different, or another parallel signaling scheme, such as one-hot encoding, or inverse one-hot encoding, may be used.

A multi-level receiver, which receives a multi-level signal as input and produces parallel binary signals as output, may be constructed with multiple comparators in parallel, which may be identical except for the threshold voltage to which each is connected. One input of each comparator may be connected to the received signal Vᵢₙ, and the other input may be connected to a threshold voltage.

Each comparator in such a multi-level receiver may be composed of a differential pair of transistors, with each transistor being connected to a resistor and to a shared current source. The current flowing through one of the resistors and one of the transistors in such a differential pair, and through the current source, dissipates power, and if there are several such comparators in a receiver then several times as much power is dissipated. Power consumption may be reduced by operating the comparators in a sequential comparison mode in which only one comparator is active at any given time, but this approach, while reducing power consumption, also reduces the speed at which the receiver is capable of operating, resulting in slower data transmission and, accordingly, a loss of at least some of the benefits of using multi-level signaling.

Thus, there is a need for a low-power, high-speed system and method for receiving a signal employing multi-level signaling.

US 5,793,816 discloses a system for receiving a multi-level signal comprising: a system input connection; a first differential pair comprising a first switch and a second switch each comprising a respective first switching terminal, second switching terminal and control terminal; the second switching terminal of the first switch of the differential pair being connected to the second switching terminal of the second switch of the differential pair, the control terminal of the first switch of the differential pair being connected to the system input connection.

Shruti K Oza et all "Low Power Folding and Interpolating ADC Using 0.18 µm Technology", ADVANCES IN COMPUTER ENGINEERING, 2010 INTERNATIONAL CONFERENCE ON, IEEE, PISCATAWAY, NJ, USA, 20 June 2010, pages 54-58, discloses a low power folding and interpolating A/D converter having a first differential pair of transistors and a second differential pair of transistors. Both of these pairs have second switching terminals (sources) connected to each other. Furthermore, the control terminal of the first switch of the first differential pair is connected to a system input connection. The control terminal of the first switch of the second differential pair is also connected to the system input connection and the first switching terminal of the second switch of the first differential pair is connected to the second switching terminal (source) of the first switch of the second differential pair and the second switching terminal (source) of the second switch of the second differential pair

### SUMMARY

Aspects of embodiments of the present invention relate to a system and method for detecting signal levels in a multi-level signaling scheme. In one embodiment, a plurality of comparators, each including a differential pair, such as a differential pair of field-effect transistors (FETs) are assembled in a stacked configuration so that in some states current flows through FETs of the plurality of differential pairs in series, resulting in a reduction in power consumption.

The present invention provides a system for receiving a multi-level signal, according to claim 1.

In one embodiment, at least one of the first switch or the second switch is a semiconductor switch.

In one embodiment, at least one the first switch or the second switch is a field effect transistor (FET).

In one embodiment, at least one the first switch or the second switch is a bipolar junction transistor (BJT).

In one embodiment, the first threshold voltage is greater than the second threshold voltage.

In one embodiment, the multi-level signal includes three adjacent levels, the first threshold voltage is half-way between a first adjacent pair of levels of the three adjacent levels, and the second threshold voltage is half-way between a second adjacent pair of levels of the three adjacent levels.

In one embodiment, the second switching terminal of the first switch of the first differential pair and the second switching terminal of the second switch of the first differential pair are connected to a first terminal of a current source; and the second terminal of the current source is connected to a first power supply connection.

In one embodiment, the first power supply connection is a ground connection of a power supply.

In one embodiment, the second power supply connection is a positive connection of a power supply.

In one embodiment, the system includes a source terminal, a drain terminal, and a gate terminal, the drain terminal being the first switching terminal of the third switch, the source terminal being the second switching terminal of the third switch, and the gate being the control terminal of the third switch.

At least some of the above and other features of the invention are set out in the claims.

### BRIEF DESCRIPTION OF THE DRAWINGS

The above and other features and advantages of the present invention will be appreciated and understood with reference to the description, claims and appended drawings wherein:
FIG. 1A is a set of three eye diagrams illustrating binary data transmission at a first clock rate and at a second clock rate, and multi-level data transmission at the first clock rate;
FIG. 1B is a hybrid block-schematic diagram of a related art multi-level receiver;
FIG. 2 is a schematic diagram of a level detector according to an embodiment of the present invention;
FIG. 3 is a schematic diagram of a level detector in a first state of operation according to an embodiment of the present invention;
FIG. 4 is a schematic diagram of a level detector in a second state of operation according to an embodiment of the present invention;
FIG. 5 is a schematic diagram of a level detector in a third state of operation according to an embodiment of the present invention;
FIG. 6 is a schematic diagram of a level detector in a fourth state of operation according to an embodiment of the present invention;
FIG. 7 is a truth table illustrating inputs and outputs of an embodiment of the present invention; and
FIG. 8 is a display employing a multi-level transmitter and a multi-level receiver according to an embodiment of the present invention.

### DETAILED DESCRIPTION

The detailed description set forth below in connection with the appended drawings is intended as a description of embodiments of a stacked comparator topology for multi-level signaling provided in accordance with the present invention and is not intended to represent the only forms in which the present invention may be constructed or utilized. The description sets forth the features of the present invention in connection with the illustrated embodiments. It is to be understood, however, that the same or equivalent functions and structures may be accomplished by different embodiments that are also intended to be encompassed within the scope of the invention. As denoted elsewhere herein, like element numbers are intended to indicate like elements or features.

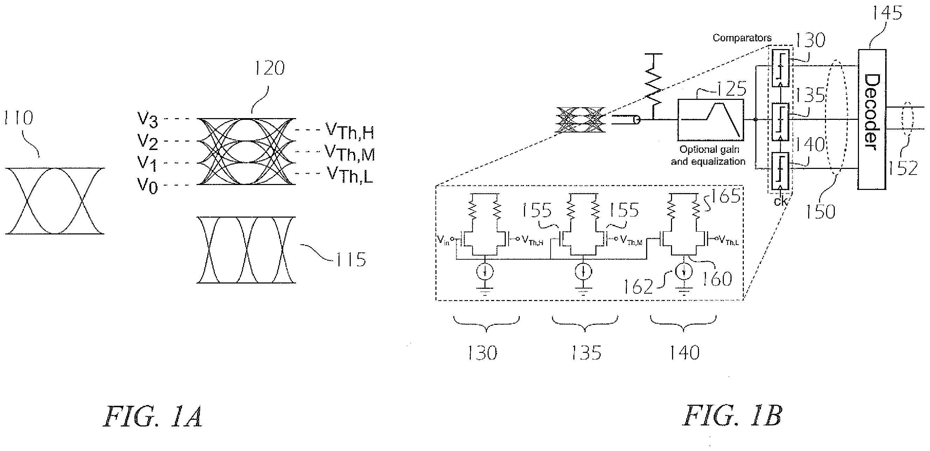

FIG. 1A, shows three eye diagrams, representing the transmission of digital data on an analog signal. A first eye diagram 110 shows data transmitted in a two-level or binary signaling scheme at a first clock rate and a first data rate. To increase the data rate, the system may be operated at a higher clock rate, i.e., with transitions spaced more closely in time, as illustrated in eye diagram 115, or multi-level signaling may be used, as illustrated in eye diagram 120. The eye diagram 120 shows four-level signaling, as may be used in PAM-4, for example.

In four-level signaling, such as PAM-4, the voltage on a signal conductor may take four values of increasing voltage, i.e., a first value, a second value, a third value, and a fourth value, which are referred to herein as V₀, V₁, V₂, and V₃. In a four-level receiver, a level detector may be used to distinguish between these four voltages, by comparing the received voltage to different threshold voltages. For example, to receive PAM-4, three threshold voltages may be used. The threshold voltages are referred to as V_{Th,H}, Vr_{h,M}, and V_{Th,L}, respectively, and may be selected so that each is approximately half-way between two adjacent levels of the multi-level signaling scheme. The threshold voltage V_{Th,L} may be half-way between the first voltage value V₀ and the second voltage value V₁, the threshold voltage V_{Th,M} may be half-way between the second voltage value V₁ and the third voltage value V₂, and the threshold voltage V_{Th,H} may be half-way between the third voltage value V₂ and the fourth voltage value V₃.

Referring to FIG. 1B, a multi-level receiver may include optional gain and equalization circuitry 125, a level detector composed of a set of comparators 130, 135, 140, and a decoder 145. The output of the level detector may be a parallel digital signal with one-hot encoding, i.e., a parallel set of signals of which at most one represents a binary "1", i.e., logic high, at any time. The decoder 145 may then convert the one-hot signal into a more compact binary signal. In the example of FIG. 1B, the receiver may receive four-level signaling such as PAM-4, the comparators may generate 3-line one-hot encoding at an intermediate bus 150, and the decoder may convert data on the 3-line one-hot bus to, e.g., data on a 2-bit parallel bus 152. Each of the comparators 130, 135, 140 may be formed as a differential pair of field-effect transistors (FETs) 155, with the sources of the two FETs connected together at a point referred to as the source connection 160, a current source 162 connected between the source connection 160 and ground, and the drain of each FET connected by a drain resistor 165 to the positive terminal of a power supply, which may also be referred to as Vcc. Each comparator has two inputs, one of which is connected to the input Vᵢₙ of the receiver, and one of which is connected to a threshold voltage; the threshold voltages are referred to as V_{Th,H}, V_{Th,M}, and V_{Th,L}, respectively, and may be selected so that each is approximately half-way between two adjacent levels of the multi-level signaling scheme, as illustrated in eye diagram 120 of FIG. 1A.

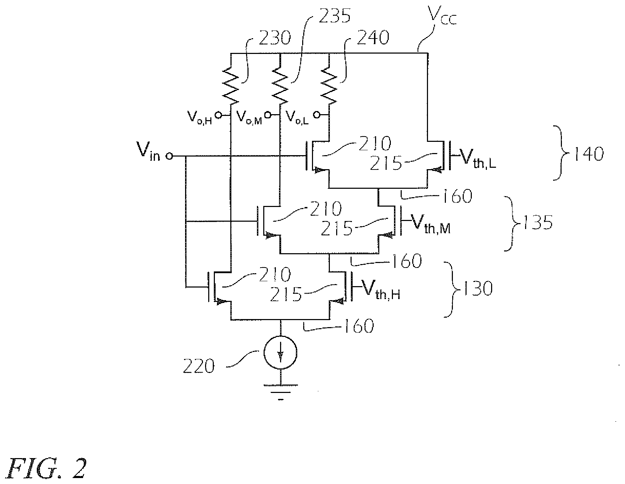

Referring to FIG. 2, in this embodiment a multi-level receiver is constructed by stacking three comparators, 130, 135, 140, suitable for use in a PAM-4 receiver. Each comparator includes a first FET 210 and a second FET 215 configured as a differential pair with sources connected together at a source connection 160. One input of each comparator is connected to the receiver input Vᵢₙ, and the other input of each comparator is connected to a threshold voltage, i.e., to V_{Th,H}, V_{Th,M}, or V_{Th,L}. The source connection of the first comparator 130 is connected to one terminal of a current source 220, the other terminal of which is connected to ground. The drain connection of the first FET 210 of each of the comparators 130, 135, 140, is connected through a resistor, i.e., a respective one of the resistors 230, 235, 240, to Vcc. The drain connection of the second FET 215 of the first comparator 130 and the drain connection of the second comparator 135 are connected to the source connection 160 of the second comparator 135 and to the source connection of the third comparator 140, respectively, and the drain connection of the second FET 215 of the third comparator 130 is connected to Vcc. Three outputs V_{O,H}, V_{O,M}, and V_{O,L}, providing the received signal in inverted one-hot encoding, are connected to the drain of the first FET 210 of the first comparator 130, the drain of the first FET 210 of the second comparator 135, and the drain of the first FET 210 of the third comparator 140, respectively. As used herein, inverted one-hot encoding refers to an encoding scheme on a parallel bus, in which at most one of the lines represents a binary "0", i.e., logic low, at any time.

Although the embodiment illustrated in FIG. 2 is composed of three comparators, each composed of a differential pair of FETs, the invention is not limited to this configuration. More or fewer comparators may be used; for example, N comparators may be used to construct a level detector for a multi-level receiver for multi-level signaling with N+1 levels. The elements forming each differential pair need not be FETs, but may be bipolar junction transistors or other switches. In general, a switch used in a differential pair may have a control terminal, a first switching terminal, and a second switching terminal. In the case of a bipolar junction transistor, for example, the base may be the control terminal and the collector and emitter may be the first and second switching terminal respectively, or the second and first switching terminal, respectively. In the case of a FET, the gate may be the control terminal and the drain and source may be the first and second switching terminal respectively, or the second and first switching terminal, respectively. Similarly, the switches may be P-channel FETs instead of N-channel FETs as illustrated in FIG. 2, or NPN or PNP transistors. If transistors are used for the switches, then, depending on the type of transistors used (e.g., NPN or PNP) the circuit may be inverted with respect to polarity, i.e., the resistors 230, 235, 240 may be connected to ground instead of Vcc, and the current source may be connected to Vcc.

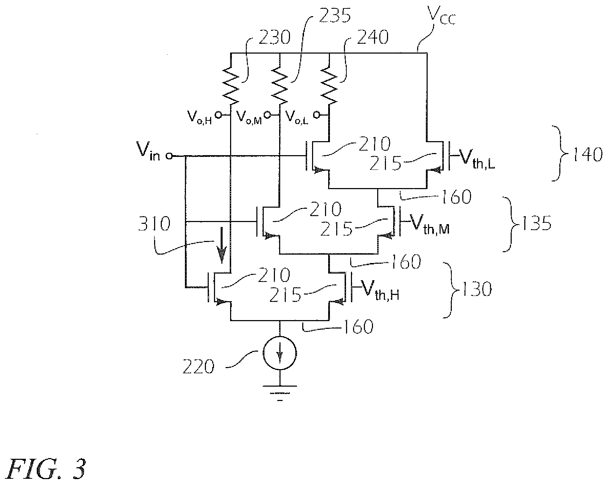

In operation, each of the three outputs V_{O,H}, V_{O,M}, and V_{O,L} is at a voltage of Vcc, customarily representing logic high or binary "1", when the first FET 210 of the corresponding comparator is switched off, and at a voltage near ground, customarily representing logic low or binary "0", when the first FET 210 of the corresponding comparator is switched on. Ordinarily, only one of the three outputs V_{O,H}, V_{O,M}, and V_{O,L} is low at any time, and the other two are high; i.e., the encoding on the parallel bus formed by V_{O,H}, V_{O,M}, and V_{O,L} is inverted one-hot encoding. For example, referring to FIG. 3, when Vᵢₙ exceeds V_{Th,H}, as it does when the received input is approximately equal to the voltage value V₃, the first FET 210 of the first comparator 130 is switched on, i.e., it conducts from drain to source, and the second FET 215 of the first comparator 130 is switched off. In this state, the principal current path from Vcc to ground is through the first resistor 230, through the first FET 210 of the first comparator 130, as indicated by the arrow representing the current path 310, and through the current source 220. In this state, the output V_{O,H}, is low and the other two outputs, V_{O,M}, and V_{O,L}, are high.

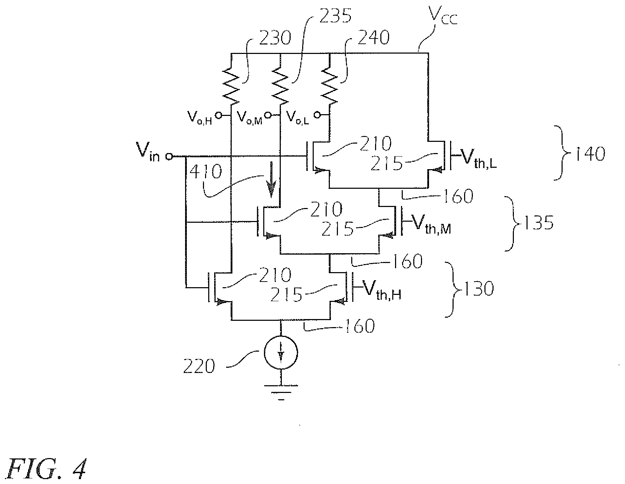

Referring to FIG. 4, when Vᵢₙ is greater than V_{Th,M}, but is less than V_{Th,H}, as it is when the received input is approximately equal to the voltage value V₂, the first FET 210 of the first comparator 130 is switched off, and the second FET 215 of the first comparator 130 is switched on, because Vᵢₙ is less than V_{Th,H}. The first FET 210 of the second comparator 135 is switched on, and the second FET 215 of the second comparator 135 is switched off, because Vᵢₙ exceeds V_{Th,M}. In this state the principal current path from Vcc to ground is through the second resistor 235, through the first FET 210 of the second comparator 135, as indicated by the arrow representing the current path 410, through the second FET 215 of the first comparator 130 and through the current source 220. In this state, the output V_{O,M}, is low and the other two outputs, V_{O,H}, and V_{O,L}, are high.

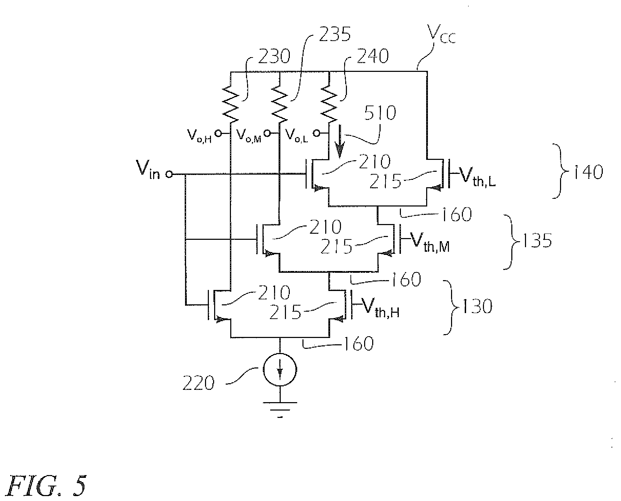

Referring to FIG. 5, when Vᵢₙ is greater than V_{Th,L} but is less than V_{Th,M}, as it is when the received input is approximately equal to the voltage value V₁, the first FET 210 of the first comparator 130 is switched off, and the second FET 215 of the first comparator 130 is switched on, because Vᵢₙ is less than V_{Th,H}. The first FET 210 of the second comparator 135 is switched off, and the second FET 215 of the second comparator 135 is switched on, because Vᵢₙ is less than V_{Th,M}. The first FET 210 of the third comparator 140 is switched on, and the second FET 215 of the third comparator 140 is switched off, because Vᵢₙ exceeds V_{Th,L}. In this state the principal current path from Vcc to ground is through the third resistor 240, through the first FET 210 of the third comparator 140, as indicated by the arrow representing the current path 510, through the second FET 215 of the second comparator 135, through the second FET 215 of the first comparator 130, and through the current source 220. In this state, the output V_{O,L}, is low and the other two outputs, V_{O,H}, and V_{O,M}, are high.

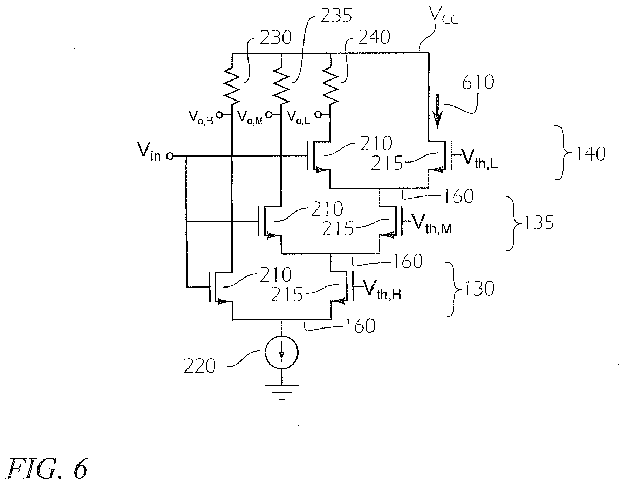

Referring to FIG. 6, when Vᵢₙ is less than V_{Th,L}, as it is when the received input is approximately equal to the voltage value V₀, the first FET 210 of the first comparator 130 is switched off, and the second FET 215 of the first comparator 130 is switched on, because Vᵢₙ is less than V_{Th,H}. The first FET 210 of the second comparator 135 is switched off, and the second FET 215 of the second comparator 135 is switched on, because Vᵢₙ is less than V_{Th,M}. The first FET 210 of the third comparator 135 is switched off, and the second FET 215 of the third comparator 135 is switched on, because Vᵢₙ is less than V_{Th,L}. In this state the principal current path from Vcc to ground is through the second FET 215 of the third comparator 140, as indicated by the arrow representing the current path 610, through the second FET 215 of the second comparator 135, through the second FET 215 of the first comparator 130, and through the current source 220. In this state, all three outputs V_{O,L}, V_{O,M}, and V_{O,H}, are high.

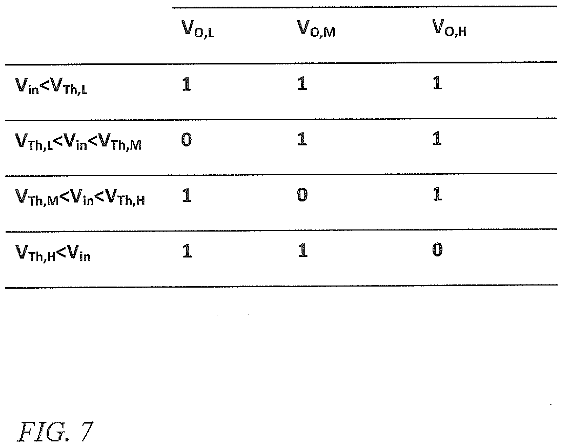

The truth table of FIG. 7 summarizes the behavior of the embodiment of FIG. 2. When Vᵢₙ is less than V_{Th,L}, all three outputs, V_{O,L}, V_{O,M}, and V_{O,H}, are high. When Vᵢₙ is greater than V_{Th,L}, and less than V_{Th,M}, V_{O,L}, is low, and V_{O,M}, and V_{O,H} are high. When Vᵢₙ is greater than V_{Th,M}, and less than V_{Th,H}, V_{O,M}, is low, and V_{O,L}, and V_{O,H} are high. When Vᵢₙ is greater than V_{Th,H}, V_{O,H} is low, and V_{O,L}, and V_{O,M}, are high.

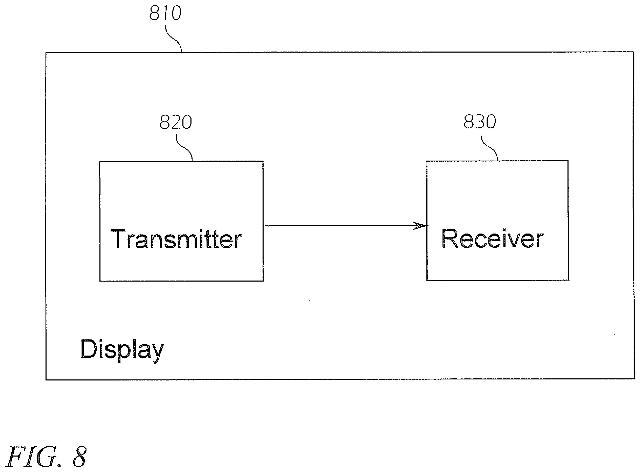

Referring to FIG. 8, in one embodiment a digital display 810, such as an organic light emitting diode display or a liquid crystal display in a television or a cell phone, includes a multi-level transmitter 820 transmitting data to a multi-level receiver 830. The multi-level receiver 830 may contain a level detector constructed according to an embodiment of the present invention. Although the present invention may be employed to transmit data between components of a display, the invention is not thereby limited, and it may be used in other applications in which data is transmitted from a transmitter to a receiver.

Although certain embodiments of a stacked comparator topology for multi-level signaling have been specifically described and illustrated herein, many modifications and variations will be apparent to those skilled in the art. Accordingly, it is to be understood that a stacked comparator topology for multi-level signaling constructed according to principles of this invention may be embodied other than as specifically described herein. The invention is also defined in the following claims, and equivalents thereof.

## Claims

1. A system for receiving a multi-level signal, the system comprising:
a system input connection (Vin);
a first differential pair (130) and a second differential pair (135);
each of the first differential pair and the second differential pair comprising a first switch (210) and a second switch (215),
each of the first switches and the second switches comprising a respective first switching terminal, a respective second switching terminal, and a respective control terminal,
the second switching terminal of the first switch of each said differential pair being connected to the second switching terminal of the second switch of that differential pair,
the control terminal of the first switch of the first differential pair being connected to the system input connection,
the control terminal of the first switch of the second differential pair being connected to the system input connection,
the first switching terminal of the second switch of the first differential pair being connected to the second switching terminal of the first switch of the second differential pair and the second switching terminal of the second switch of the second differential pair,
the control terminal of the second switch of the first differential pair being connected to a voltage source at a first threshold voltage (V_{th,H}),
the control terminal of the second switch of the second differential pair being connected to a voltage source at a second threshold voltage (V_{th,M}),
the first switching terminal of the first switch of the first differential pair being connected to a first system output connection (V_{o,H}) and a first terminal of a first load element (230),
the first switching terminal of the first switch of the second differential pair being connected to a second system output connection (V_{o,M}) and a first terminal of a second load element (235),
a second terminal of the first load element (230) being connected to a second power supply connection, and
a second terminal of the second load element (235) being connected to the second power supply connection;
**characterized in that** the first load element (230) and the second load element (235) are each formed by a respective resistor, both of which are directly connected to the second power supply connection.

2. A system according to claim 1, wherein at least one of the first switch (210) or the second switch (215) is a semiconductor switch.

3. A system according to claim 2, wherein at least one the first switch (210) or the second switch (215) is a field effect transistor (FET).

4. A system according to claim 2 or 3, wherein at least one the first switch (210) or the second switch (215) is a bipolar junction transistor (BJT).

5. A system according to any preceding claim, wherein the first threshold voltage (V_{th,H}) is greater than the second threshold voltage (V_{th,M}).

6. A system according to any one of claims 1 to 4, wherein the second threshold voltage (V_{th,M}) is greater than the first threshold voltage (V_{th,H}).

7. A system according to any preceding claim, wherein:
the multi-level signal comprises three adjacent levels,
the first threshold voltage (V_{th,H}) is half-way between a first adjacent pair of levels of the three adjacent levels, and
the second threshold voltage (V_{th,M}) is half-way between a second adjacent pair of levels of the three adjacent levels.

8. A system according to any preceding claim, wherein:
the second switching terminal of the first switch (210) of the first differential pair and the second switching terminal of the second switch (215) of the first differential pair are connected to a first terminal of a current source (220); and
the second terminal of the current source is connected to a first power supply connection.

9. A system according to claim 8, wherein the first power supply connection is a ground connection of a power supply.

10. A system according to claim 9, wherein the second power supply connection is a positive connection of a power supply.

## Patentansprüche

1. System zum Empfangen eines mehrstufigen Signals, wobei das System umfasst:
einen Systemeingangsanschluss (Vin);
ein erstes Differentialpaar (130) und ein zweites Differentialpaar (135);
wobei das erste Differentialpaar und das zweite Differentialpaar jeweils einen ersten Schalter (210) und einen zweiten Schalter (215) umfassen,
die ersten Schalter und die zweiten Schalter jeweils einen jeweiligen ersten Schaltanschluss, einen jeweiligen zweiten Schaltanschluss und einen jeweiligen Steueranschluss umfassen,
der zweite Schaltanschluss des ersten Schalters jedes Differentialpaars an den zweiten Schaltanschluss des zweiten Schalters jenes Differentialpaars angeschlossen ist,
der Steueranschluss des ersten Schalters des ersten Differentialpaars an den Systemeingangsanschluss angeschlossen ist,
der Steueranschluss des ersten Schalters des zweiten Differentialpaars an den Systemeingangsanschluss angeschlossen ist,
der erste Schaltanschluss des zweiten Schalters des ersten Differentialpaars an den zweiten Schaltanschluss des ersten Schalters des zweiten Differentialpaars und den zweiten Schaltanschluss des zweiten Schalters des zweiten Differentialpaars angeschlossen ist,
der Steueranschluss des zweiten Schalters des ersten Differentialpaars an eine Spannungsquelle mit einer ersten Schwellenspannung (V_{th,H}) angeschlossen ist,
der Steueranschluss des zweiten Schalters des zweiten Differentialpaars an eine Spannungsquelle mit einer zweiten Schwellenspannung (V_{th,M}) angeschlossen ist,
der erste Schaltanschluss des ersten Schalters des ersten Differentialpaars an einen ersten Systemausgangsanschluss (V_{o,H}) und einen ersten Anschluss eines ersten Lastelements (230) angeschlossen ist,
der erste Schaltanschluss des ersten Schalters des zweiten Differentialpaars an einen zweiten Systemausgangsanschluss (V_{o,M}) und einen ersten Anschluss eines zweiten Lastelements (235) angeschlossen ist,
ein zweiter Anschluss des ersten Lastelements (230) an einen zweiten Stromversorgungsanschluss angeschlossen ist und
ein zweiter Anschluss des zweiten Lastelements (235) an den zweiten Stromversorgungsanschluss angeschlossen ist;
**dadurch gekennzeichnet, dass** das erste Lastelement (230) und das zweite Lastelement (235) jeweils durch einen jeweiligen Widerstand gebildet sind, die beide direkt an den zweiten Stromversorgungsanschluss angeschlossen sind.

2. System nach Anspruch 1, wobei der erste Schalter (210) oder/und der zweite Schalter (215) ein Halbleiterschalter ist/sind.

3. System nach Anspruch 2, wobei der erste Schalter (210) oder/und der zweite Schalter (215) ein Feldeffekttransistor (FET) ist/sind.

4. System nach Anspruch 2 oder 3, wobei der erste Schalter (210) oder/und der zweite Schalter (215) ein Bipolartransistor (BPT) ist/sind.

5. System nach einem der vorangehenden Ansprüche, wobei die erste Schwellenspannung (V_{th,H}) größer als die zweite Schwellenspannung (V_{th,M}) ist.

6. System nach einem der Ansprüche 1 bis 4, wobei die zweite Schwellenspannung (V_{th,M}) größer als die erste Schwellenspannung (V_{th,H}) ist.

7. System nach einem der vorangehenden Ansprüche, wobei:
das mehrstufige Signal drei benachbarte Stufen umfasst,
die erste Schwellenspannung (V_{th,H}) auf halbem Wege zwischen einem ersten benachbarten Paar Stufen der drei benachbarten Stufen liegt und
die zweite Schwellenspannung (V_{th,M}) auf halbem Wege zwischen einem zweiten benachbarten Paar Stufen der drei benachbarten Stufen liegt.

8. System nach einem der vorangehenden Ansprüche, wobei:
der zweite Schaltanschluss des ersten Schalters (210) des ersten Differentialpaars und der zweite Schaltanschluss des zweiten Schalters (215) des ersten Differentialpaars an einen ersten Anschluss einer Stromquelle (220) angeschlossen sind; und
der zweite Anschluss der Stromquelle an einen ersten Stromversorgungsanschluss angeschlossen ist.

9. System nach Anspruch 8, wobei der erste Stromversorgungsanschluss ein Erdanschluss einer Stromversorgung ist.

10. System nach Anspruch 9, wobei der zweite Stromversorgungsanschluss ein positiver Anschluss einer Stromversorgung ist.

## Revendications

1. Système destiné à recevoir un signal multiniveau, le système comprenant :
une connexion d'entrée de système (Vin) ;
une première paire différentielle (130) et une seconde paire différentielle (135) ;
la première paire différentielle et la seconde paire différentielle comprenant chacune un premier commutateur (210) et un second commutateur (215),
chacun des premiers commutateurs et des seconds commutateurs comprenant une première borne de commutation respective, une seconde borne de commutation respective, et une borne de commande respective,
la seconde borne de commutation du premier commutateur de chacune desdites paires différentielles étant connectée à la seconde borne de commutation du second commutateur de cette paire différentielle,
la borne de commande du premier commutateur de la première paire différentielle étant connectée à la connexion d'entrée de système,
la borne de commande du premier commutateur de la seconde paire différentielle étant connectée à la connexion d'entrée de système,
la première borne de commutation du second commutateur de la première paire différentielle étant connectée à la seconde borne de commutation du premier commutateur de la seconde paire différentielle et à la seconde borne de commutation du second commutateur de la seconde paire différentielle,
la borne de commande du second commutateur de la première paire différentielle étant connectée à une source de tension à une première tension de seuil (V_{th,H}),
la borne de commande du second commutateur de la seconde paire différentielle étant connectée à une source de tension à une seconde tension de seuil (V_{th,M}),
la première borne de commutation du premier commutateur de la première paire différentielle étant connectée à une première sortie de système (V_{o,H}) et à une première borne de premier élément de charge (230),
la première borne de commutation du premier commutateur de la seconde paire différentielle étant connectée à une seconde connexion de sortie de système (V_{o,M}) et à une première borne de second élément de charge (235),
une seconde borne du premier élément de charge (230) étant connectée à une seconde connexion d'alimentation électrique, et
une seconde borne du second élément de charge (235) étant connectée à la seconde connexion d'alimentation électrique ;
**caractérisé en ce que** le premier élément de charge (230) et le second élément de charge (235) sont constitués chacun d'une résistance respective, tous deux étant connectés directement à la seconde connexion d'alimentation électrique.

2. Système selon la revendication 1, dans lequel au moins l'un du premier commutateur (210) ou du second commutateur (215) est un interrupteur à semiconducteur.

3. Système selon la revendication 2, dans lequel au moins l'un du premier commutateur (210) ou du second commutateur (215) est un transistor à effet de champ (TEC).

4. Système selon la revendication 2 ou 3, dans lequel au moins l'un du premier commutateur (210) ou du second commutateur (215) est un transistor bipolaire à jonctions (BJT, *bipolar junction transistor*).

5. Système selon l'une quelconque des revendications précédentes, dans lequel la première tension de seuil (V_{th,H}) est supérieure à la seconde tension de seuil (V_{th,M})

6. Système selon l'une quelconque des revendications 1 à 4, dans lequel la seconde tension de seuil (V_{th,M}) est supérieure à la première tension de seuil (V_{th,H}).

7. Système selon l'une quelconque des revendications précédentes, dans lequel :
le signal multiniveau comprend trois niveaux adjacents,
la première tension de seuil (V_{th,H}) est à mi-chemin entre une première paire de niveaux adjacents des trois niveaux adjacents, et
la seconde tension de seuil (V_{th,M}) est à mi-chemin entre une seconde paire de niveaux adjacents des trois niveaux adjacents.

8. Système selon l'une quelconque des revendications précédentes, dans lequel :
la seconde borne de commutation du premier commutateur (210) de la première paire différentielle et la seconde borne de commutation du second commutateur (215) de la première paire différentielle sont connectées à une première borne de source de courant (220) ; et
la seconde borne de la source de courant est connectée à une première connexion d'alimentation électrique.

9. Système selon la revendication 8, dans lequel la première connexion d'alimentation électrique est une mise à la terre d'alimentation électrique.

10. Système selon la revendication 9, dans lequel la seconde connexion d'alimentation électrique est une connexion positive d'alimentation électrique.
